# EUROPEAN PATENT APPLICATION

(11) **EP 4 535 437 A1**
(43) Date of publication of application: **09.04.2025**
(21) Application number: 23838706.2
(22) Date of filing: 29.06.2023
(51) Int. Cl.: H01L 31/18, H01L 31/05

(54) **SOLAR CELL AND INTERCONNECTION METHOD THEREFOR**

(30) Priority: 13.07.2022 CN 202210828187
(71) Applicant: TONGWEI SOLAR (HEFEI) CO., LTD., Hefei, Anhui 230088 (CN)
(72) Inventor: CHEN, Dengyun, Hefei, Anhui 230088 (CN); DING, Changlin, Hefei, Anhui 230088 (CN); YIN, Bingwei, Hefei, Anhui 230088 (CN); ZHU, Baobao, Hefei, Anhui 230088 (CN); ZHOU, Huaming, Hefei, Anhui 230088 (CN)
(74) Representative: Gill Jennings & Every LLP
(86) International application number: PCT/CN2023/103681
(87) International publication number: WO 2024/012213

(57) **Abstract**

The present application relates to a solar cell (100) and an interconnection method therefor. The interconnection method for the solar cell (100) comprises: using a thermosetting adhesive (130) to pre-affix a welding wire (140) onto a surface of a gate line (120) of a cell (110) used to connect with the welding wire (140), each gate line (120) used to connect with the welding wire (140) being partially covered by the thermosetting adhesive (130); heating the cell (110) having the welding wire (140) pre-affixed, such that the thermosetting adhesive (130) is cured, and the welding wire (140) and the gate line (120) are alloyed and connected, the curing temperature of the thermosetting adhesive (130) and the melting point of a surface coating (142) of the welding wire (140) both being lower than the temperature at which the cell (110) is heated.

## Description

The present application claims priority to Chinese patent application No. 202210828187.9, entitled "SOLAR CELL AND INTERCONNECTING METHOD FOR SOLAR CELL", filed on July 13, 2022, the disclosure of which is incorporated herein by reference in its entirety.

### TECHNICAL FIELD

The present application relates to the technical field of solar cell, and in particular, to a solar cell and an interconnecting method for solar cell.

### BACKGROUND

With the development of solar green energy, solar cells with high efficiency and low cost are becoming more and more popular in the market. In the process of manufacturing solar cells, the grid lines on the surfaces of the cells need to be connected by welding wires to realize interconnection.

However, the existing interconnection methods have poor interconnection effect, which may lead to poor contact or poor adhesion between welding wire and grid line, resulting in poor electric current transmission yield. In addition, in an early stage of the existing interconnection process, excessive silver paste is required to be consumed to manufacture the grid lines for subsequent interconnection, resulting in increased costs.

### SUMMARY

According to various embodiments of the present application, a solar cell and an interconnecting method for solar cell are provided.

In a first aspect, the present application provides an interconnecting method for solar cell, including: pre-fixing a welding wire to a surface of a grid line of a cell configured to be connected to the welding wire, by a thermosetting adhesive, and wherein each grid line configured to be connected to the welding wire is partially covered with the thermosetting adhesive; and
heating the cell having the welding wire pre-fixed thereon, to cure the thermosetting adhesive and form an alloyed connection between the welding wire and the grid line. A curing temperature of the thermosetting adhesive and a melting point of a surface coating of the welding wire are both lower than a temperature at which the cell is heated.

In a second aspect, the present application provides a solar cell, including a cell, a grid line, a thermosetting adhesive, and a welding wire. The grid line is located on a surface of the cell. A surface of the grid line is partially covered with the thermosetting adhesive. The welding wire is located on a side of the grid line away from the cell, and the welding wire is connected to the thermosetting adhesive. A region, which is not covered with the thermosetting adhesive, of the surface of the grid line connected to the welding wire is in an alloyed connection with the welding wire.

### BRIEF DESCRIPTION OF THE DRAWINGS

In order to more clearly illustrate the technical solutions in the embodiments of the present application or the prior art, a brief description is given below for the drawings referred in the description of the embodiments or the prior art. Obviously, the drawings in the following description are merely for some embodiments of the present application. For those of ordinary skill in the art, drawings of other embodiments can also be obtained based on these drawings without involving any inventive effort.
FIG. 1 shows a flowchart of an interconnecting method for solar cell according to the present application.
FIG. 2 shows a schematic structural view of a solar cell according to the present application.
FIG. 3 shows a partially enlarged view of portion A in FIG. 2.
FIG. 4 shows a sectional view taken along a B-B direction in FIG. 3.

Reference numerals: 100, solar cell; 110, cell; 120, grid line; 130, thermosetting adhesive; 140, welding wire; 141, base material; 142, coating.

### DETAILED DESCRIPTION

Technical solutions in the embodiments of the present application are described below clearly and completely with reference to the drawings in the embodiments of the present application. Obviously, the described embodiments are only some, not all, of the embodiments of the present application. Based on the embodiments of the present application, all other embodiments obtained by a person of ordinary skills in the art without involving inventive effort belong to the scope of the present application.

In the case where specific conditions are not indicated in the embodiments, conventional conditions or conditions recommended by the manufacturer were followed. In the case where the manufacturer is not indicated, the reagents or instruments used are conventional products that are commercially available.

The methods for interconnecting solar cell known to the inventors include the following two main methods.

In the first method, a certain number of PAD points are disposed on the cell of a solar cell, and the welding wire and the silver grid line on the cell are welded together by lamp welding.

In the second method, the grid line and the welding wire are physically connected to each other by a glue.

It is found by the inventors that, in the first method, the connecting force between the welding wire and the grid line is weak. If there is no PAD point on the cell, the welding wire may be separated from the cell during subsequent transporting, resulting in poor electric current transmission yield. Therefore, the connecting force between the welding wire and the grid line must be ensured by the PADs. However, the PAD points being disposed on the cell may result in excessive silver paste consumption in the early stage of interconnection when manufacturing the grid line, resulting in higher costs.

It is also found by the inventors that in the second method, there was only physical contact between the grid line and the welding wire, and the electrical contact between the grid line and the welding wire was poor. When laminating a plurality of stacked cells, there may be a gap between the non-glued part of the grid lines of the cells and the welding wire. However, electroluminescent (EL) test prior to lamination cannot determine if the electrical contact is poor, resulting in an unguaranteed yield. In addition, when laminating the plurality of stacked cells, the glue on the surface of the grid line may easily penetrate between the welding wire and the cell, resulting in poor electrical contact between the grid line and the welding wire. During the flow of glue, it is also easy for the welding wire to deviate from the cell, and the yield and reliability of the solar cell cannot be guaranteed.

In order to solve the problems existing in the first and second methods, the present application provides an interconnecting method for solar cell, including: pre-fixing a welding wire to a surface of a grid line of a cell that is configured to be connected to the welding wire, by a thermosetting adhesive, the surface of the grid line being, and heating the cell having the welding wire pre-fixed thereon, so that the thermosetting adhesive is cured and an alloyed connection is formed between the welding wire and the grid line.

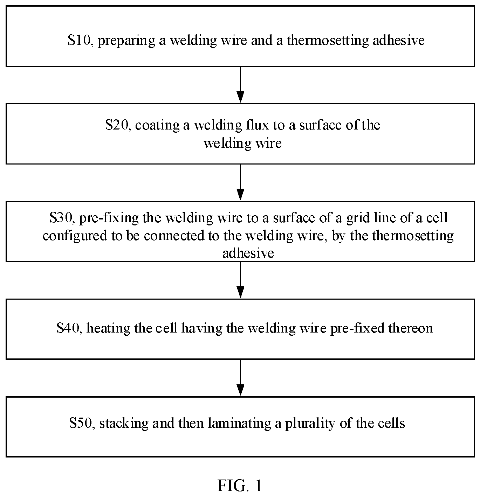

FIG. 1 shows a flowchart of the interconnecting method for solar cell according to the present application. Referring to FIG. 1, the interconnecting method for solar cell includes the following steps.

At S 10, a welding wire and a thermosetting adhesive are prepared.

In the present application, a curing temperature of the thermosetting adhesive and a melting point of the surface coating of the welding wire are both lower than a temperature at which the cell is heated.

Since the curing temperature of the thermosetting adhesive and the melting point of the surface coating of the welding wire are both lower than the temperature at which the cell is heated, in the subsequent heating process of the cell sheet, it is possible to melt the surface coating of the welding wire and form an alloyed connection between the welding wire and the grid line, to enable an effective electrical contact between the welding wire and the grid line; and it is also possible to cure the thermosetting adhesive connecting the welding wire and the grid line, so that the bonding force between the welding wire and the grid line can be effectively improved by means of the bonding force of the thermosetting adhesive, which is conducive to avoiding the case that the welding wire and the grid line are separated from each other due to the weak connecting force caused by the alloyed connection only formed between the welding wire and the grid line, and thus which is beneficial to improve the electric current transmission yield.

In the present application, the surface coating of the welding wire is made of a tin-containing alloy. The tin-containing alloy can be effectively melted and in an alloyed connection with the grid line under heating conditions. Since the tin-containing alloy has good ductility and plasticity, it is beneficial to further improve the electrical connection effect between the welding wire and the grid line.

By way of example, the tin-containing alloy includes at least one of a tin-lead-bismuth alloy, a tin-bismuth alloy, a tin-bismuth-silver alloy, a tin-bismuth-copper alloy, and a tin-indium alloy.

In the present application, the tin-containing alloy can be selected as Sn43Pb43Bi14.

It should be noted that the base material of the welding wire (that is, the material covered by the coating) is not limited in the present application. By way of example, the base material of the welding wire may be copper, which has good conductivity and low cost.

For a heterojunction cell among the solar cells, the amorphous silicon layer of the heterojunction cell is susceptible to damage and failure at high temperatures. When the solar cell is a heterojunction cell, the subsequent temperature at which the cell having the welding wire pre-fixed thereon is heated may be less than or equal to 200°C, to avoid failure of the amorphous silicon layer of the heterojunction cell, so the melting point of the surface coating of the welding wire may be set to be in a range of 150°C to 180°C.

By way of example, when the solar cell is the heterojunction cell, the melting point of the surface coating of the welding wire may be 150°C, 155°C, 160°C, 170°C, 180°C, or the like.

The thermosetting adhesive may include at least one selected from the group consisting of an epoxy resin adhesive, a phenolic resin adhesive, a polyurethane adhesive, an acrylic adhesive, and an organic silicone adhesive. The thermosetting adhesive can be cured quickly and effectively under the heating condition, and the bonding force after curing is strong, which is beneficial to further improve the connecting force between the welding wire and the grid line.

Further, in the present application, the curing time of the thermosetting adhesive is in a range of 20 s to 30 s, which can improve the interconnection efficiency of the cells. By way of example, the curing time of the thermosetting adhesive may be 20 s, 22 s, 25 s, 27 s, 30 s, or the like.

When the solar cell is the heterojunction cell, the curing temperature of the thermosetting adhesive is set to be in a range of 150°C to 180°C. By way of example, the curing temperature of the thermosetting adhesive may be 150°C, 155°C, 160°C, 170°C, 180°C, or the like.

It should be noted that, in other feasible embodiments, the solar cell is not limited to the heterojunction cell. For other types of solar cells, the temperature at which the cell having the welding wire pre-fixed thereon is heated may also be greater than 200°C. Therefore, the temperature of the surface coating of the welding wire and the curing temperature of the thermosetting adhesive can be adjusted according to the specific temperature of "heating the cell having the welding wire pre-fixed thereon", as long as the melting point of the surface coating of the welding wire and the curing temperature of the thermosetting adhesive are both lower than the temperature at which the cell is heated.

At S20, welding flux is coated to a surface of the welding wire.

Before pre-fixing the welding wire to the surface of the grid line of the cell by the thermosetting adhesive, the welding flux is coated to the surface of the welding wire, which can promote the effect of alloyed connection (i.e., welding) between the welding wire and the grid line, and can advantageously avoid the poor effect of alloyed connection caused by oxidation reaction in the process of forming the alloyed connection.

It should be noted that, in other feasible embodiments, the welding flux may not be coated to the surface of the welding wire, that is, step S20 may not be performed, and step S30 may be performed directly after step S10.

At S30, the welding wire is pre-fixed to a surface of a grid line of a cell configured to be connected to the welding wire, by the thermosetting adhesive.

The thermosetting adhesive also has a certain bonding force before it is cured. Before heating the cell, the welding wire is pre-fixed to the surface of the grid line of the cell by the thermosetting adhesive, which can enable a preliminary connection and positioning between the welding wire and the grid line and avoid the welding wire from being separated from the grid line in the subsequent alloying process.

It should be noted that the specific grid line to which the welding wire is pre-fixed is not limited in the present application, and the welding wire may be pre-fixed on the surface of a fine busbar, or may be pre-fixed on the surface of a finger, or may be pre-fixed at an intersection of the busbar and the finger.

The welding wire may be pre-fixed to the surface of the grid line by the thermosetting adhesive by: coating the thermosetting adhesive on the surface of the grid line of the cell, and then placing the welding wire on the corresponding grid line and making the welding wire contact the thermosetting adhesive; or coating the thermosetting adhesive to the surface of the welding wire, and then placing the welding wire on the corresponding grid line and make the thermosetting adhesive contact the grid line.

When the welding wire is pre-fixed to the surface of the grid line of the cell configured to be connected to the welding wire, by the thermosetting adhesive, each grid line configured to be connected to the welding wire is partially covered with the thermosetting adhesive. Since each grid line configured to be connected to the welding wire is partially covered with the thermosetting adhesive, a region, which is not covered with the thermosetting adhesive, of the surface of each grid line configured to be connected to the welding wire can be in an alloyed connection with the welding wire. In the process of pre-fixing the welding wire to the surface of the grid line by the thermosetting adhesive as described above, the welding wire may be in complete contact, incomplete contact, or even not in contact with the grid line. In the case of the welding wire being not in contact with the grid line, contact and connection can be achieved by appropriate pressurization during subsequent process of heating the grid line and the welding wire and forming the alloyed connection between the grid line and the welding wire.

Further, in the present application, each grid line configured to be connected to the welding wire is covered with the thermosetting adhesive in a spaced manner, so that the connecting force between the welding wire and the grid line is further improved, which helps to further avoiding the case that the welding wire and the grid line are separated from each other, and is conducive to improving the electric current transmission yield.

Further, 2 to 5 spots on each grid line configured to be connected to the welding wire are covered with the thermosetting adhesive. By way of example, 2, 3, 4 or 5 spots on each grid line configured to be connected to the welding wire may be covered with the thermosetting adhesive.

In the present application, each of the spots on each of the grid lines covered by the thermosetting adhesive is a spot where the grid line configured to be connected to the welding wire intersects with other grid line on the cell. With the above arrangement, the connecting force between the welding wire and the grid line is further improved,

At S40, the cell having the welding wire pre-fixed thereon is heated.

As described above, the curing temperature of the thermosetting adhesive and the melting point of the surface coating of the welding wire are both lower than the temperature at which the cell is heated. By heating the cell having the welding wire pre-fixed thereon at a temperature above the curing temperature of the thermosetting adhesive and the melting point of the surface coating of the welding wire, it is possible to melt the surface coating of the welding wire and form an alloyed connection between the welding wire and the grid line, to enable an effective electrical contact between the welding wire and the grid line; and it is also possible to cure the thermosetting adhesive connecting the welding wire and the grid line, so that the bonding force between the welding wire and the grid line can be effectively improved by means of the bonding force of the thermosetting adhesive, which is conducive to avoiding the case that the welding wire and the grid line are separated from each other due to the weak bonding force caused by the alloyed connection only formed between the welding wire and the grid line, and thus which is beneficial to improving the electric current transmission yield.

Before the subsequent lamination (i.e., S50), the thermosetting adhesive is cured and the alloyed connection between the welding wire and the grid line is formed, which can effectively avoid the uncured thermosetting adhesive from flowing between the welding wire and the cell during the lamination, thus avoiding the poor physical contact between the grid line and the welding wire and the deviation of the welding wire from the cell, and effectively improving the yield of the solar cell.

In addition, the interconnecting method for solar cell provided in the present application can enable a reliable connection between the grid line and the welding wire without disposing the PAD point on the surface of the cell, which effectively reduces silver paste consumption caused by disposing PAD points in the process of manufacturing the grid line in the early stage, and effectively reduces the cost in the process of manufacturing the cell in the early stage.

When the solar cell is the heterojunction cell, the cell having the welding wire pre-fixed thereon is heated at a temperature less than or equal to 200°C, which is beneficial for effectively avoiding the failure of the amorphous silicon layer of the heterojunction cell due to high temperature.

Further, when the solar cell is the heterojunction cell, the cell can be heated at 150°C, 155°C, 160°C, 165°C, 170°C, 175°C, 180°C, or the like.

In some embodiments of the present application, in the process of heating the cell having the welding wire pre-fixed thereon, pressure may be applied to a surface of the welding wire away from the cell, which can effectively ensure that the welding wire is in an effective contact with the grid line, so that an effective alloyed connection is formed between the welding wire and the grid line, and an effective electrical connection between the welding wire and the grid line is realized. It is also beneficial to avoid slipping movement or deviation of the welding wire relative to the grid line due to melting of the surface coating of the welding wire, and thus to avoid the case that the poor contact between the welding wire and the grid line due to slipping movement or deviation between the welding wire and the grid line may result in poor electric current transmission yield.

Further, in the present application, a pressure in a range of 10 kpa to 100 kpa may be applied to the surface of the welding wire away from the cell. Within the above pressure range, slipping movement or deviation of the welding wire relative to the grid line due to melting of the surface coating of the welding wire can be effectively avoided. If the pressure is too low, some regions of the surface of the grid line may not be in an effective contact with the surface coating of the welding wire as it melts and the alloyed connection between the welding wire and the grid line may not be effectively formed, such that a gap may be formed between the surface of the grid line and the welding wire, resulting in reduced connecting force between the grid line and the welding wire. If the pressure is too high, the area of the surface of the cell covered with the surface coating of the welding wire as it melts may be too large, which may reduce the thickness of the welding wire coating that is between the grid line and the welding wire and configured to form the alloyed connection, resulting in poor connecting force of the alloyed connection between the welding wire and the coating.

By way of example, a pressure of 10 kpa, 20 kpa, 50 kpa, 70 kpa, 100 kpa, or the like may be applied to the surface of the welding wire away from the cell.

It should be noted that the implementation of applying pressure is not limited in the present application, for example, the pressure may be applied by employing a pressure disc on the surface of the welding wire away from the cell.

In order to avoid the uneven heating of the cell caused by directly heating the cell at a high-temperature, and further help to reduce the adverse effects on the performance of the cell, the present application adopts a multi-stage gradual heating method to heat the cell having the welding wire pre-fixed thereon.

A heterojunction cell is taken as an example, given by the inventors, when the solar cell is the heterojunction cell, the multi-stage gradual heating method includes: sequentially heating the cell to 5°C - 45°C and keeping the temperature for 0.5 s - 3 s, heating the cell to 50 °C - 90 °C and keeping the temperature for 0.5 s - 3 s, heating the cell to 100 °C - 120 °C and keeping the temperature for 0.5 s - 3 s, heating the cell to 130 °C - 150 °C and keeping the temperature for 0.5 s - 3 s, and finally heating the cell to 160 °C - 200 °C and keeping the temperature for 15 s - 30 s.

It should be noted that, in other feasible embodiments, the solar cell is not limited to the heterojunction cell. For other types of solar cells, the temperature at which the cell is heated may be set according to the actual situation, as long as the temperature at which the cell is heated does not cause damage to the cell, and the temperature at which the cell is heated is greater than the curing temperature of the thermosetting adhesive and the melting point of the surface coating of the welding wire.

At S50, a plurality of cells are stacked and then laminated.

The plurality of cells are stacked and laminated to form a cell string. The temperature for laminating is lower than the melting point of the surface coating of the welding wire, which helps to avoid the poor alloying (i.e., welding) effect between the welding wire and the grid line caused by the secondary melting of the surface coating of the welding wire.

A heterojunction cell is taken as an example, given by the inventors, when the solar cell is the heterojunction cell, the temperature for laminating is in a range of 130°C - 150°C. By way of example, the temperature for the laminating may be 130°C, 135°C, 140°C, 142°C, 145°C, 150°C, or the like.

It should be noted that, in other feasible embodiments, the solar cell is not limited to the heterojunction cell. For other types of solar cells, the temperature for laminating may be adjusted according to the actual situation, as long as the temperature for laminating is lower than the melting point of the surface coating of the welding wire.

The present application provides a solar cell, which is manufactured by the above interconnecting method for solar cell.

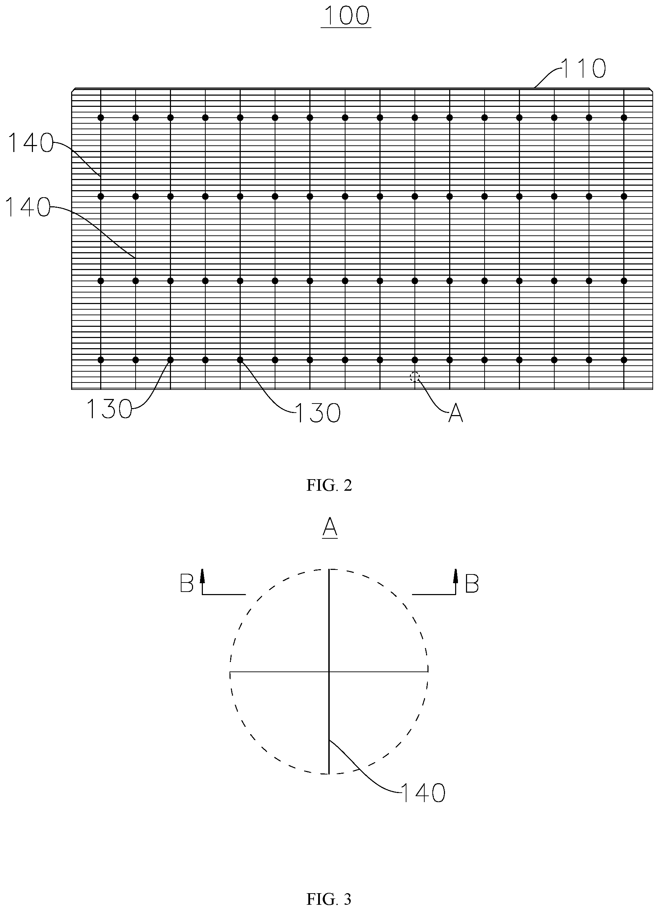

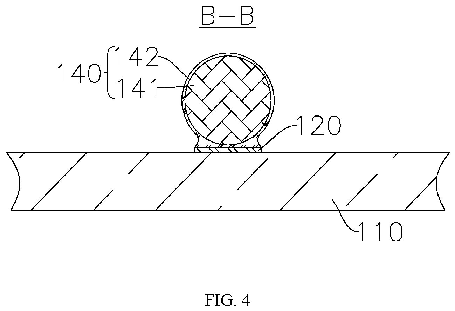

The present application further provides a solar cell. FIG. 2 shows a schematic structural view of a solar cell 100 according to the present application. FIG. 3 shows a partially enlarged view of portion A in FIG. 2. FIG. 4 shows a sectional view taken along the B-B direction in FIG. 3. Referring to FIGS. 2 to 4, the present application provides a solar cell 100. The solar cell 100 includes a cell 110, a grid line 120, a thermosetting adhesive 130, and a welding wire 140.

The grid line 120 is located on the surface of the cell 110. The surface of the grid line 120 is partially covered with the thermosetting adhesive 130. The welding wire 140 is located on a side of the grid line 120 away from the cell 110 and connected to the thermosetting adhesive 130. A region, which is not covered with the thermosetting adhesive 130, of the surface of the grid line 120 configured to be connected to the welding wire 140 is in an alloyed connection with the welding wire 140.

The welding wire 140 includes a base material 141 and a surface coating 142 covering the surface of the substrate 141. The surface coating 142 is in an alloyed connection with the grid line 120 on the cell 110.

The solar cell provided by the present application can enable an effective electrical connection between the welding wire and the grid line, and effectively improve the bonding force between the welding wire and the grid line, which can avoid the case that the welding wire and the grid line are separated from each other due to the weak bonding force caused by the alloyed connection only formed between the welding wire and the grid line, and it is beneficial to improve the electric current transmission yield.

The characteristics and performance of the interconnecting method for solar cell of the present application are further described in detail below with reference to the embodiments.

### Embodiment 1

This embodiment provides an interconnecting method for heterojunction cell, which includes the following steps.

A silicone thermosetting adhesive is coated on a surface of a fine busbar of a cell, and then a welding wire coated with a welding flux on its surface is placed on the surface of the fine busbar. The cell is heated to 25°C and kept for 1 s, then heated to 70°C and hold for 1 s, then heated to 110°C and hold for 1 s, then heated to 140°C and hold for 1 s, finally heated to 180°C and heated for 20 s. In the process of heating, a pressure disc is placed on the surface of the welding wire away from the fine busbar to apply a pressure of 50 kpa. After a plurality of cells are cooled to room temperature, the cells are stacked and laminated at 140°C to form a cell string.

The curing temperature of the silicone thermosetting adhesive is 160°C. The base material of the welding wire is copper. The surface coating of the welding wire is made of Sn43Pb43Bi14. The melting point of the surface coating of the welding wire is 160°C. 4 spots on the surface of each fine busbar are coated with the silicone thermosetting adhesive. The fine busbar intersects with the finger at each of these coated spots.

### Embodiment 2

This embodiment provides an interconnecting method for heterojunction cell. The steps of this embodiment are substantially the same as those of Embodiment 1, and except that: the surface of the welding wire is not coated with the welding flux, and the welding wire is directly placed on the surface of the fine busbar coated with the silicone thermosetting adhesive.

### Embodiment 3

This embodiment provides an interconnecting method for heterojunction cell. The steps of this embodiment are substantially the same as those of Embodiment 1, and except that: no pressure disc is placed on the surface of the welding wire away from the fine busbar in the process of heating.

### Embodiment 4

This embodiment provides an interconnecting method for heterojunction cell. The steps of this embodiment are substantially the same as those of Embodiment 1, and except that: a pressure disc is placed on the surface of the welding wire away from the fine busbar to apply a pressure of 10 kpa in the process of heating.

### Embodiment 5

This embodiment provides an interconnecting method for heterojunction cell. The steps of this embodiment are substantially the same as those of Embodiment 1, and except that: a pressure disc is placed on the surface of the welding wire away from the fine busbar to apply a pressure of 100 kpa in the process of heating.

### Comparative Embodiment

The present comparative embodiment provides an interconnecting method for heterojunction cell, which includes the following steps. A surface of a fine busbar of a cell is coated with ethylene vinyl acetate (EVA) hot melt adhesive, then a welding wire is placed on the surface of the fine busbar, and a plurality of cells are stacked and then laminated at 140°C to form a cell string.

The base material of the welding wire is copper. The surface coating of the welding wire is made of Sn43Pb43Bi14. The melting point of the surface coating of the welding wire is 160°C. 4 spots on the surface of each fine busbar are coated with the EVA hot melt adhesive. The fine busbar intersects with the finger at each of these coated spots.

### Experimental Example

The heterojunction cell strings obtained in Embodiments 1-5 and the Comparative Embodiment were characterized by tensile force between the welding wire and the fine busbar and EL (electroluminescence defect detection) performance, and the experimental results were shown in Table 1.

**Table 1**

| | Measurement results of tensile force between welding wire and fine busbar | Observation of EL |
|---|---|---|
| Embodiment 1 | Tensile force at the adhesive spot being 2 N, and tensile force at the non-adhesive spot being 0.5 N | The overall brightness being uniform, indicating a good alloy formation effect |
| Embodiment 2 | Tensile force at the adhesive spot being 2 N, and tensile force at the non-adhesive spot being 0.1 N | Dark zones being formed locally, indicating that the alloy formation being slightly uneven locally, and a false connection being formed |
| Embodiment 3 | Tensile force at the adhesive spot being 2 N, and tensile force at the non-adhesive spot being 0.2 N | Dark zones being formed locally, indicating that the alloy formation being slightly uneven locally, and a false connection being formed |
| Embodiment 4 | Tensile force at the adhesive spot being 2 N, and tensile force at the non-adhesive spot being 0.3 N | Dark zones being formed locally, indicating that the alloy formation being slightly uneven locally, and a false connection being formed |
| Embodiment 5 | Tensile force at the adhesive spot being 2 N, and tensile force at the non-adhesive spot being 0.3 N | Cracks being formed locally |
| Comparative Embodiment | Tensile force at the adhesive spot being 0.5 N, and tensile force at the non-adhesive spot being 0.2 N | Dark zones being formed in most parts |

| | | |
|---|---|---|
| Note: "measurement result of tensile force between welding wire and fine busbar" refers to a critical value of the tensile force in a direction away from the fine busbar, that causes the welding wire and the fine busbar to be separated from each other when such tensile force is applied to the welding wire. "Tensile force at the adhesive spot" in Table 1 refers to a critical value of the tensile force in a direction away from the fine busbar, that causes the welding wire and the fine busbar to be separated from each other when such tensile force is applied to the region of the welding wire "corresponding to spots coated with the silicone thermosetting adhesive or spots coated with the EVA hot melt adhesive". "Tensile force at the non-adhesive spot" refers to an average critical value of the tensile force in a direction away from the fine busbar, that causes the welding wire and the fine busbar to be separated from each other when such tensile force is applied to regions other than the region of the welding wire "corresponding to spots coated with the silicone thermosetting adhesive or spots coated with the EVA hot melt adhesive". | | |

It can be seen from Table 1 that the tensile force at the non-adhesive spot of Embodiment 1 was greater than the tensile forces at the non-adhesive spots of Embodiments 2-5, and the EL observation results of Embodiment 1 were better than the observation results of EL of Embodiments 2-5. This means that coating welding flux before pre-fixing the welding wire on the surface of the fine busbar, applying pressure to the surface of the welding wire away from the fine busbar when heating the cell, and the magnitude of pressure can affect the tensile force at the non-adhesive spot, that is, can affect the alloyed connection effect between the welding wire and the grid line.

Further, the tensile force at the non-adhesive spot and the tensile force at the adhesive spot of Embodiment 1 were greater than the tensile force at the non-adhesive spot and the tensile force at the adhesive spot of Comparative Embodiment respectively, and the EL observation results of Embodiment 1 was better than the observation results of EL of the Comparative Embodiment, which means that the interconnecting method for solar cell provided by the present application can significantly improve the bonding force between the welding wire and the grid line.

To sum up, the interconnecting method for solar cell provided by the present application can enable an effective electrical connection between the welding wire and the grid line, effectively improve the bonding force between the welding wire and the grid line, and effectively reduce silver paste consumption caused by disposing PAD points in the process of manufacturing the grid line in the early stage, thereby effectively reducing the cost.

The technical features of the embodiments above may be combined arbitrarily. To make the description concise, not all possible combinations of the technical features in the above embodiments are described. However, as long as there are no contradictions in the combinations of these technical features, all of the combinations should be considered to be within the scope of the specification.

The embodiments above only represent several implementations of the present application, and the description thereof is relatively specific and detailed, but it should not be construed as limiting the scope of the patent. It should be noted that for those skilled in the art, various modifications and improvements may be made without departing from the concept of the present application, and all these modifications and improvements fall within the protection scope of the present application. Therefore, the scope of protection of the patent application shall be subject to the appended claims.

## Claims

1. An interconnecting method for solar cell, comprising:
pre-fixing a welding wire to a surface of a grid line of a cell configured to be connected to the welding wire, by a thermosetting adhesive, wherein each grid line configured to be connected to the welding wire is partially covered with the thermosetting adhesive; and
heating the cell having the welding wire pre-fixed thereon, to cure the thermosetting adhesive and form an alloyed connection between the welding wire and the grid line, wherein a curing temperature of the thermosetting adhesive and a melting point of a surface coating of the welding wire are lower than a temperature at which the cell is heated.

2. The interconnecting method according to claim 1, further comprising: stacking and then laminating a plurality of the cells after the heating the cell having the welding wire pre-fixed thereon,
wherein a temperature of the laminating is lower than the melting point of the surface coating of the welding wire.

3. The interconnecting method according to claim 1 or 2, wherein the solar cell is a heterojunction cell; the temperature at which the cell is heated is in a range of 150°C to 200°C; the curing temperature of the thermosetting adhesive is in a range of 150°C to 180°C; the melting point of the surface coating of the welding wire is in a range of 150°C to 180°C; and a temperature for laminating is in a range of 130°C to 150°C.

4. The interconnecting method according to claim 3, wherein a curing time of the thermosetting adhesive is in a range of 20 s to 30 s.

5. The interconnecting method according to claim 1, wherein the thermosetting adhesive comprises at least one of an epoxy resin adhesive, a phenolic resin adhesive, a polyurethane adhesive, an acrylic adhesive, and an organic silicone adhesive.

6. The interconnecting method according to claim 1, wherein the surface coating of the welding wire is made of a tin-containing alloy.

7. The interconnecting method according to claim 6, wherein the tin-containing alloy comprises at least one of a tin-lead-bismuth alloy, a tin-bismuth alloy, a tin-bismuth-silver alloy, a tin-bismuth-copper alloy, and a tin-indium alloy.

8. The interconnecting method according to claim 6, wherein the tin-containing alloy is Sn43Pb43Bi14.

9. The interconnecting method according to claim 1, further comprising: coating a welding flux to a surface of the welding wire before the pre-fixing the welding wire to the surface of the grid line of the cell by the thermosetting adhesive.

10. The interconnecting method according to claim 1, wherein the heating the cell having the welding wire pre-fixed thereon further comprises: applying pressure to a surface of the welding wire away from the cell.

11. The interconnecting method according to claim 10, wherein a magnitude of pressure is in a range from 10 kpa to 100 kpa.

12. The interconnecting method according to claim 1, wherein the pre-fixing the welding wire to the surface of the grid line of the cell by the thermosetting adhesive comprises:
coating the thermosetting adhesive on the surface of the grid line of the cell, and then placing the welding wire on the corresponding grid line, so that the welding wire is in contact with the thermosetting adhesive.

13. The interconnecting method according to claim 1, wherein the pre-fixing the welding wire to the surface of the grid line of the cell by the thermosetting adhesive comprises:
coating the thermosetting adhesive to a surface of the welding wire, and then placing the welding wire on the corresponding grid line, so that the grid line is in contact with the thermosetting adhesive.

14. The interconnecting method according to claim 1, wherein the heating the cell having the welding wire pre-fixed thereon comprises: heating the cell having the welding wire pre-fixed thereon by a multi-stage gradual heating method.

15. The interconnecting method according to claim 1, wherein each grid line configured to be connected to the welding wire is covered with the thermosetting adhesive in a spaced manner.

16. The interconnecting method according to claim 15, wherein 2 to 5 spots on each grid line configured to be connected to the welding wire are covered with the thermosetting adhesive.

17. The interconnecting method according to claim 16, wherein the thermosetting adhesive covers spots where the grid line configured to be connected to the welding wire intersects with other grid lines on the cell.

18. A solar cell, comprising a cell, a grid line, a thermosetting adhesive and a welding wire,
wherein the grid line is located on a surface of the cell, and a surface of the grid line is at least partially covered with the thermosetting adhesive; wherein the welding wire is located on a side of the grid line away from the cell, and the welding wire is connected to the thermosetting adhesive; and wherein a region, which is not covered with the thermosetting adhesive, of the surface of the grid line connected to the welding wire is in an alloyed connection with the welding wire.
